(19) Europäisches Patentamt

European Patent Office

Office européen des brevets

(11) **EP 0 910 801 B1**

(12) **EUROPÄISCHE PATENTSCHRIFT**

(45) Veröffentlichungstag und Bekanntmachung des Hinweises auf die Patenterteilung:
**19.09.2001 Patentblatt 2001/38**

(21) Anmeldenummer: **97932707.9**

(22) Anmeldetag: **25.06.1997**

(51) Int Cl.$^7$: **G01R 33/032**, G01R 15/24

(86) Internationale Anmeldenummer:
**PCT/DE97/01319**

(87) Internationale Veröffentlichungsnummer:
**WO 98/01763 (15.01.1998 Gazette 1998/02)**

(54) **VERFAHREN ZUR INTENSITÄTSNORMIERUNG OPTISCHER SENSOREN ZUM MESSEN PERIODISCH SCHWANKENDER ELEKTRISCHER ODER MAGNETISCHER FELDSTÄRKEN**

PROCESS FOR STANDARDISING THE INTENSITY OF OPTICAL SENSORS USED FOR MEASURING PERIODICALLY OSCILLATING ELECTRIC OR MAGNETIC FIELD INTENSITIES

PROCEDE DE NORMALISATION DE L'INTENSITE DE CAPTEURS OPTIQUES UTILISES POUR MESURER DES CHAMPS MAGNETIQUES OU ELECTRIQUES D'INTENSITE PERIODIQUEMENT VARIABLE

(84) Benannte Vertragsstaaten:
**AT BE CH DE FR GB IT LI SE**

(30) Priorität: **09.07.1996 DE 19627633**

(43) Veröffentlichungstag der Anmeldung:
**28.04.1999 Patentblatt 1999/17**

(73) Patentinhaber: **SIEMENS AKTIENGESELLSCHAFT 80333 München (DE)**

(72) Erfinder: **MENKE, Peter D-91362 Pretzfeld (DE)**

(56) Entgegenhaltungen:
**DE-A- 4 432 146          US-A- 4 564 754
US-A- 4 894 608**

• **MENKE P ET AL: "TEMPERATURE COMPENSATION IN MAGNETOOPTIC AC CURRENT SENSORS USING AN INTELLIGENT AC-DC SIGNAL EVALUATION" JOURNAL OF LIGHTWAVE TECHNOLOGY, Bd. 13, Nr. 7, 1.Juli 1995, Seiten 1362-1370, XP000597658**

**Beschreibung**

Die Erfindung betrifft ein Verfahren zur Intensitätsnormierung eines optischen Sensors zum Messen einer periodisch schwankenden elektrischen und/oder magnetischen Feldstärke nach dem Oberbegriff des Patentanspruchs 1.

Ein bekanntes Beispiel für einen optischen Sensor der genannten Art ist ein zweikanaliger polarimetrischer optischer Wechselstrom- und/oder Wechselspannungssensor. Derartige Sensoren gehen beispielsweise aus US-A-4 564 754, DE-A-4 432 146 und US-A-4 894 608 hervor.

Ein solcher Sensor nutzt die Tatsache, daß beim Hindurchschicken polarisierten Lichts durch ein elektrisches und/oder magnetisches Feld aufgrund bestimmter physikalischer Effekte (beispielsweise Faraday-Effekt, Pockels-Effekt) eine von der Feldstärke dieses Feldes abhängige Veränderung des Polarisationszustandes des Lichts hervorgerufen wird und gemessen werden kann.

Wechselstrom und Wechselspannung erzeugen in ihrer Umgebung ein elektrisches bzw. magnetisches Feld periodisch schwankender Feldstärke, die eine periodische Schwankung des Polarisationszustandes des durch dieses Feld geschickten polarisierten Lichts erzeugt.

"Zweikanalig" bedeutet bei dem bekannten Sensor, daß das durch das Feld geschickte polarisierte Licht einem Polarisationsstrahlteiler zugeführt wird, der das zugeführte Licht in zwei Lichtanteile jeweils festen aber voneinander verschiedenen, beispielsweise zueinander orthogonalen Polarisationszustandes zerlegt, deren Intensitäten vom Polarisationszustand des durch das Feld geschickten und dem Teiler zugeführten Lichts abhängen.

Jeder auf diese Weise erzeugte Lichtanteil bildet somit ein Intensitätssignal, dessen Intensität von der Feldstärke des Feldes abhängt. Als Intensitätssignal ist hier nicht nur der Lichtanteil selbst, sondern auch jedes andere erzeugte Signal zu verstehen, dessen Intensität sich wie die Intensität eines Lichtanteils in Abhängigkeit von der Feldstärke des zu messenden Feldes ändert. Ein Beispiel ist das von einem optoelektrischen Wandler, beispielsweise eine Diode, aus einem Lichtanteil erzeugte elektrische Intensitätssignal.

Die Intensitäten der beiden entstandenen Lichtanteile bzw. Intensitätssignale ergänzen sich von Dämpfungsverlusten abgesehen zur Intensität des durch das Feld geschickten und dem Polarisationsstrahlteiler zugeführten Lichts. Ist die Intensität dieses zugeführten Lichts konstant, ist auch die Summe der Intensitäten der beiden Lichtanteile bzw. Intensitätssignale konstant.

Um Einflüsse einer nicht konstanten Intensität des durch das Feld geschickten und dem Polarisationsstrahlteiler zugeführten Lichts zu eliminieren, wird üblicherweise eine Intensitätsnormierung durchgeführt.

Ein gängiges Verfahren zur Intensitätsnormierung eines optischen Sensors der genannten Art ist die -/+ -Division, d.h. aus den beiden Lichtanteilen bzw. Intensitätssignalen wird eine Größe gebildet, die einem Quotienten aus einer Differenz zwischen den Intensitäten der beiden Lichtanteile und der Summe der Intensitäten der beiden Lichtanteile entspricht (siehe dazu z. B. US-A-4 564 754).

Die -/+ -Division ist in der Lage, auch eine sehr schnell schwankende Intensität des durch das Feld geschickten und dem Polarisationsstrahlteiler zugeführten Lichts zu kompensieren.

Aufgrund des feldstärkebedingt periodisch schwankenden Polarisationszustandes des durch das Feld geschickten und dem Polarisationsstrahlteiler zugeführten Lichts weisen die Intensitäten der beiden vom Teiler erzeugten Lichtanteile bzw. beiden Intensitätssignale jeweils eine entsprechende periodische Schwankung auf, d.h., sie setzen sich jeweils aus einem konstanten Intensitätsanteil und einem in Abhängigkeit von der gemessenen Feldstärke periodisch schwankenden Intensitätsanteil zusammen.

Die periodisch schwankenden Intensitätsanteile der Intensitäten der beiden vom Teiler erzeugten Lichtanteile bzw. beiden Intensitätssignale sind zueinander gegenphasig und weisen im Idealfall eine Amplitude gleichen Betrags auf, was zur Folge hat, daß neben der Summe der konstanten Intensitätsanteile auch die Summe der periodisch schwankenden Intensitätsanteile beider Lichtanteile bzw. Intensitätssignale konstant ist, wenn die Intensität des durch das Feld geschickten und dem Polarisationsstrahlteiler zugeführten Lichts konstant ist.

Im Realfall ist jedoch auch bei konstanter Intensität des durch das Feld geschickten und dem Polarisationsstrahlteiler zugeführten Lichts vielfach die Summe der Intensitäten der beiden vom Teiler erzeugten Lichtanteile bzw. beiden Intensitätssignale nicht konstant, sondern schwankt periodisch.

Beispielsweise tritt dies auf, wenn die zueinander gegenphasig periodisch schwankenden Intensitätsanteile der Intensitäten der beiden vom Polarisationsstrahlteiler erzeugten Lichtanteile bzw. beiden Intensitätssignale Amplituden voneinander verschiedenen Betrags aufweisen.

Dies kann beispielsweise darauf beruhen, daß ein den einen erzeugten Lichtanteil vom Polarisationsstrahlteiler zu beispielsweise einem optoelektrischen Wandler zum Umwandeln der Intensität dieses Lichtanteils in ein entsprechendes elektrisches Intensitätssignal führender Lichtleiter, beispielsweise eine optische Faser, eine andere Dämpfung als ein den anderen erzeugten Lichtanteil zu einem optoelektrischen Wandler zum Umwandeln der Intensität dieses anderen Lichtanteils in ein entsprechendes elektrisches Intensitätssignal führender Lichtleiter aufweist.

Ein von der -/+ -Division verschiedenes gängiges Verfahren zur Intensitätsnormierung eines optischen Sensors der genannten Art, das als AC/DC-Division bekannt ist (siehe dazu beispielsweise US-A-4 894 608), kann vom Polarisationsstrahlteiler erzeugte und derartige zueinander gegenphasig periodisch schwankende Intensitätsanteile mit Amplituden unterschiedlichen Betrags enthaltende Lichtanteile bzw. entsprechende Intensitätssignale kompensieren. Dieses Verfahren versagt jedoch bei schnellen Schwankungen der Intensität des durch das Feld geschickten Lichts.

Der Erfindung liegt die Aufgabe zugrunde, ein Verfahren zur Intensitätsnormierung eines oben näher bezeichneten optischen Sensors bereitzustellen, das sowohl schnelle Schwankungen der Intensität des durch das Feld geschickten Lichts als auch gegenphasig periodisch schwankende Intensitätsanteile mit Amplituden unterschiedlichen Betrags in von dem durch das Feld geschickten Licht erzeugten Lichtanteilen bzw. Intensitätssignalen kompensieren kann.

Diese Aufgabe wird durch ein Verfahren gemäß dem Oberbegriff des Anspruchs 1 gelöst, welches die im kennzeichnenden Teil dieses Anspruchs angegebenen Merkmale aufweist.

Bei dem erfindungsgemäßen Verfahren ist es vorteilhafterweise gleichgültig, ob die zueinander gegenphasig periodisch schwankenden Intensitätsanteile der beiden erzeugten Lichtanteile bzw. Intensitätssignale Amplituden gleichen oder unterschiedlichen Betrags aufweisen, da zur erforderlichen Bildung des Quotienten stets entsprechend schwankende Signale zur Verfügung stehen, deren Amplituden im wesentlichen gleichen Betrag aufweisen.

Das erfindungsgemäße Verfahren vereinigt vorteilhafterweise zum großen Teil die Vorteile der -/+ -Division mit denen der AC/DC-Division.

Die von den Intensitäten der beiden von dem durch das Feld geschickten Licht erzeugten Lichtanteile bzw. beiden Intensitätssignale erfindungsgemäß abgeleiteten Signale werden bevorzugter- und vorteilhafterweise nach Anspruch 2 mit Hilfe eines Korrekturfaktors gebildet. Es genügt dabei, wenn die Intensität nur eines der beiden von dem durch das Feld geschickten Licht erzeugten Lichtanteile bzw. Intensitätssignale, der bzw. das frei gewählt werden kann, mit einem Korrekturfaktor multipliziert wird, die Intensität des anderen Lichtanteils bzw. Intensitätssignals dagegen nicht. Von den beiden gewonnenen Signalen stellt in diesem Fall eines die mit dem Korrekturfaktor multiplizierte Intensität eines Lichtanteils bzw. Intensitätssignals und das andere die unveränderte Intensität des anderen Lichtanteils bzw. Intensitätssignals dar. Man könnte auch sagen, der Korrekturfaktor des anderen gewonnenen Signals ist gleich eins.

Es können unter Umständen auch beide gewonnenen Signale jeweils die Intensität des ihm zugeordneten Lichtanteils bzw. Intensitätssignals mit je einem Korrekturfaktor multipliziert darstellen, so daß jedes gewonnene Signal durch Multiplikation mit je einem von eins verschiedenen Korrekturfaktor entstanden ist.

Ein bevorzugtes und vorteilhaftes Verfahren zur Bestimmung eines Korrekturfaktors ist im Anspruch 3 angegeben.

Eine bei diesem Verfahren erforderlicher periodisch schwankender Intensitätsanteil eines Intensitätssignals kann beispielsweise nach Maßgabe des Anspruchs 4 gewonnen werden.

Besonders vorteilhaft ist es jedoch, den periodisch schwankenden Intensitätsanteil gemäß Anspruch 5 durch Filterung des diesen Intensitätsanteil enthaltenen Intensitätssignals zu gewinnen.

In diesem Zusammenhang sei darauf hingewiesen, daß das erfindungsgemäße Verfahren auf der grundsätzlichen Annahme beruht, daß der periodisch schwankende Intensitätsanteil des Intensitätssignals aus im wesentlichen nur von der periodisch schwankenden Feldstärke allein verursachten Schwankungen besteht, denen im wesentlichen keine Störschwankungen überlagert sind, d.h. Störschwankungen, die in bezug auf die feldstärkeverursachten Schwankungen unter einem vorgebbaren zulässigen Maß liegen.

Vielfach können jedoch beträchtliche Störschwankungen auftreten, die beispielsweise in der gleichen Größenordnung wie die feldstärkeverursachten Schwankungen liegen und verschiedene Ursachen haben können.

Beispielsweise können solche beträchtlichen Störschwankungen durch mechanische Vibrationen am Sensor und/oder den die Intensitätssignale führenden optischen Kanälen aus den verschiedensten Gründen zeitweilig oder dauerhaft auftreten.

Solche beträchtlichen Störschwankungen auf beiden Intensitätssignalen können je nach Ursache mehr oder weniger gleichphasig oder zueinander gegenphasig sein und Amplituden gleichen oder unterschiedlichen Betrags aufweisen.

In dem Fall, daß bei allen Frequenzen, bei denen die feldstärkeverursachten Schwankungen Amplituden relativ großen Betrags haben, die Störschwankungen einen relativ kleinen Betrag aufweisen, können die Störschwankungen, gleich welcher Art, durch Herausfiltern aller bei anderen Frequenzen liegenden Störschwankungen mit Amplituden relativ großen Betrags weitgehend unschädlich gemacht werden, insbesondere dann, wenn die Amplituden relativ kleinen Betrags der Frequenzkomponenten der Störschwankungen unter dem vorgebbaren zulässigen Maß liegen.

Oftmals genügt eine einfache Bandpaßfilterung mit einem Bandpaßfilter.

Besonders günstige Verhältnisse liegen vor, wenn die feldstärkeverursachten Schwankungen im wesentlichen bei einer einzigen Frequenz liegen, wie dies beispielsweise bei durch Wechselstrom oder Wechselspannung einer festen Frequenz von z.B. 50 Hz verursachten periodisch schwankender Feldstärke der Fall ist. Hier ist es selten, daß Störschwankungen genau bei dieser festen Frequenz eine Frequenzkomponente mit einer Amplitude ausreichend großen Betrags aufweisen, vielmehr wird in der Regel dieser Betrag hinreichend klein sein. Es genügt dann zum Unschädlichmachen der Störschwankungen ein sehr schmalbandiges Filter, das im wesentlichen nur die feste Frequenz durchläßt, alle anderen Frequenzen aber sperrt.

Demnach hat die Vorgehensweise gemäß Anspruch 5 den beträchtlichen Vorteil, daß das erfindungsgemäße Verfahren auch bei beachtlichen Störschwankungen erfolgreich anwendbar ist.

Als bestimmte amplitudenbezogene Größe bei der Korrekturfaktorbestimmung nach Anspruch 3 kann beispielsweise der Betrag einer Amplitude des periodisch schwankenden Intensitätsanteils eines Intensitätssignals oder auch ein Effektivwert dieses Intensitätsanteils benutzt werden. Zweckmäßiger ist es jedoch, als bestimmte amplitudenmäßige Größe gemäß Anspruch 6 ein zeitliches Mittel der Beträge mehrerer Amplituden des jeweiligen periodisch schwankenden Intensitätsanteils zu verwenden, da in diesem Fall der ermittelte Korrekturfaktor von vorgegebenen und/oder zufälligen Amplitudenschwankungen unabhängiger wird. In jedem Fall wird bei der erforderlichen Bildung des Quotienten mit den auf eine der vorstehend beschriebenen Möglichkeiten ermittelten Größen eine Division null durch null vermieden.

Eine alternative Ausgestaltung des in Anspruch 2 angegebenen Verfahrens geht aus Anspruch 7 hervor.

Das erfindungsgemäße Verfahren kann mit analogen und/oder digitalen Bausteinen realisiert werden.

Eine Anordnung zur Durchführung des erfindungsgemäßen Verfahrens ist im Anspruch 8 angegeben. Bevorzugte und vorteilhafte Ausgestaltungen der Anordnung nach Anspruch 8 gehen aus den Ansprüchen 9 bis 15 hervor.

Bei dem erfindungsgemäßen Verfahren und der erfindungsgemäßen Anordnung geht vorteilhafterweise keine Information über den

Polarisationszustand des Gleichlichtanteils eines einem Polarisationsstrahlteiler zugeführten optischen Signals verloren.

Die Erfindung wird in der nachfolgenden Beschreibung an Hand der Figuren näher erläutert. Es zeigen:

Figur 1    in schematischer Darstellung einen beispielhaften optischen Sensor zum Messen einer periodisch schwankenden magnetischen Feldstärke zusammen mit einer beispielhaften Anordnung zur Durchführung des erfindungsgemäßen Verfahrens in blockschaltbildhafter Darstellung,

Figur 2    beispielhafte Intensitätssignale mit zueinander gegenphasig periodisch schwankenden Intensitätsanteilen auf der Zeitachse,

Figur 3    von den Intensitätssignalen nach Figur 2 abgeleitete Signale, die zueinander gegenphasig periodisch schwankende Signalintensitäten mit Amplituden im wesentlichen gleichen Betrags aufweisen,

Figur 4    ein Blockschaltbild einer beispielhaften Korrekturfaktor-Bestimmungseinrichtung der Anordnung nach Figur 1 und

Figur 5    beispielhaft ein Frequenzspektrum mit Frequenzkomponenten der feldstärkeverursachten Schwankungen und von Störschwankungen,

Figur 6    ein alternatives Teil der Korrekturfaktor-Bestimmungseinrichtung nach Figur 4 und

Figur 7    eine alternative Ausgestaltung einer in der Anordnung nach Anspruch 1 enthaltenen Ableitungseinrichtung.

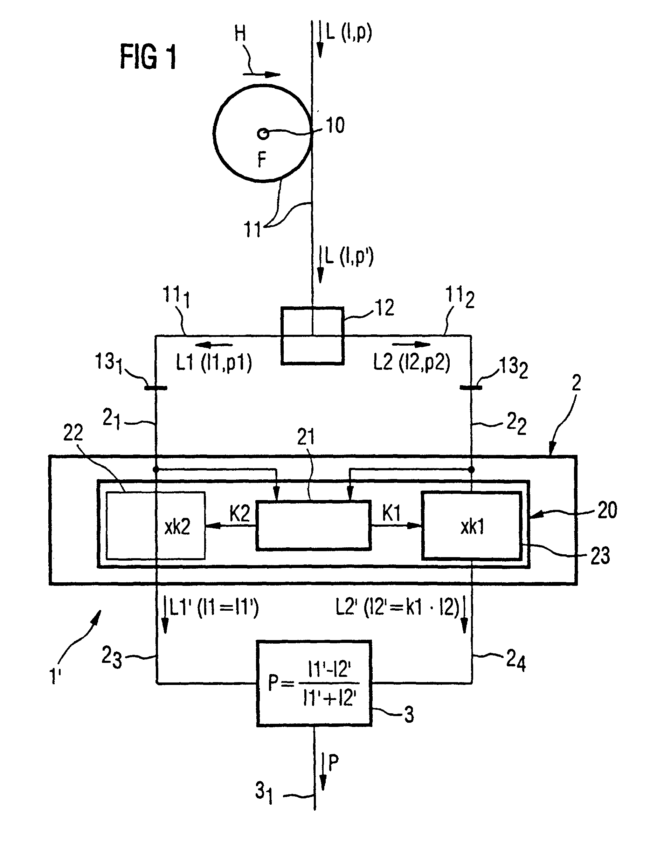

In der Figur 1 ist der beispielhafte optische Sensor zum Messen einer periodisch schwankenden elektrischen und/oder magnetischen Feldstärke mit 1 und die beispielhafte Anordnung zur erfindungsgemäßen Intensitätsnormierung dieses Sensors mit 1' bezeichnet.

Der beispielhafte Sensor 1 ist speziell und ohne Beschränkung der Allgemeinheit ein zweikanaliger polarimetrischer Wechselstromsensor, der einen den Wechselstrom führenden und beispielsweise senkrecht zur Zeichenebene verlaufenden elektrischen Leiter 10 umgebenden optischen Leiter 11 zum Führen polarisierten Lichts L einer bestimmten Intensität I und eines bestimmten Polarisationszustandes p unter Erhaltung dieses Polarisationszustandes p aufweist.

Der optische Leiter 11 kann beispielsweise aus einer den Leiter 10 umgebenden Faserspule bestehen.

Der den elektrischen Leiter 10 umgebende optische Leiter 11 liegt im Bereich des vom Wechselstrom erzeugten und den Leiter 10 umgebenden magnetischen Feldes, dessen ständig in der Richtung wechselnde magnetische Feldstärke $\vec{H}$ parallel zur Zeichenebene und senkrecht zum Leiter 10 gerichtet ist.

In den optischen Leiter 11 wird das Licht L der bestimmten Intensität I und des bestimmten Polarisationszustandes p eingekoppelt. Das eingekoppelte Licht L erfährt beim Durchlaufen des den elektrischen Leiter 10 umgebenden magnetischen Wechselfeldes aufgrund bestimmter physikalischer Effekte, beispielsweise des Faraday-Effektes, eine Änderung des Polarisationszustandes p derart, daß ein entsprechend dem Wechselstrom symmetrisch um einen bestimmten festen Polarisationszustand $p_0'$ periodisch schwankender Polarisationszustand p' entsteht.

Das Licht L dieses schwankenden Polarisationszustandes p' wird im optischen Leiter 11 einem Po-

larisationsstrahteiler 12 zugeführt, der dieses Licht L in zwei polarisierte Lichtanteile L1 und L2 jeweils festen aber voneinander verschiedenen Polarisationszustandes p1 bzw. p2 zerlegt, wobei der Polarisationsstrahlteiler 12 derart relativ zum festen Polarisationszustand $p_0'$ des ihm zugeführten Lichts L eingestellt ist, daß die Intensitäten I1 und I2 der beiden erzeugten Lichtanteile L1 und L2 entsprechend dem periodisch schwankenden Polarisationszustand p' des zugeführten Lichts L zueinander gegenphasig periodisch schwankende Intensitäten I1 und I2 aufweisen, d.h., die Intensität I1 des Lichtanteils L1 setzt sich aus einem Gleichintensitätsanteil I1DC, dem ein periodisch schwankender Intensitätsanteil I1AC überlagert ist, und die Intensität I2 des Lichtanteils L2 aus einem Gleichintensitätsanteil I2DC, dem ein periodisch schwankender Intensitätsanteil I2AC überlagert ist zusammen,.wobei die beiden periodisch schwankenden Intensitätsanteile I1AC und I2AC zueinander gegenphasig sind.

Im idealen störungsfreien Fall ist der Betrag |A1| der auf den Gleichintensitätsanteil I1DC der Intensität I1 des einen Lichtanteils L1 bezogenen Amplitude A1 des periodisch schwankenden Intensitätsanteils I1AC im wesentlichen gleich dem Betrag |A2| der auf den Gleichintensitätsanteil I2DC der Intensität I2 des anderen Lichtanteils L1 bezogenen Amplitude A2 des periodisch schwankenden Intensitätsanteils I2AC, d.h. es gilt im wesentlichen |A1| = |A2| = |A|.

Die Intensitäten Intensitätssignale I1 und I2 der beiden erzeugten Intensitätssignale L1 und L2 ergänzen sich in diesem Fall abgesehen von Dämpfungsverlusten im Teiler 12 zur Intensität I des zugeführten Lichts L. Ist diese Intensität I konstant, ist auch die Summe I1+I2 der Intensitäten I1 und I2 der beiden Intensitätssignale L1 und L2 konstant.

Das Intensitätssignal L1 wird direkt oder in einem optischen Leiter $11_1$ beispielsweise einer optoelektrischen Wandlerstelle $13_1$ zugeführt, in der das Intensitätssignal L1 in von der optischen in elektrische Form gebracht wird. Ebenso wird das Intensitätssignal L2 direkt oder in einem optischen Leiter $11_2$ einer optoelektrischen Wandlerstelle $13_2$ zugeführt, in der dieses Intensitätssignal L2 von der optischen in elektrische Form gebracht wird.

Das elektrische Intensitätssignal L1 wird in einem elektrischen Leiter $2_1$ und das elektrische Intensitätssignal L2 in einem elektrischen Leiter $2_2$ einer Gewinnungseinrichtung 2 der erfindungsgemäßen Anordnung zur Intensitätsnormierung zugeführt.

Weisen die beiden optischen Leiter $11_1$ und $11_2$ relativ zueinander verschiedene Dämpfungen auf, haben die periodisch schwankenden Intensitätsanteile I1AC bzw. I2AC der Intensitätssignale L1 und L2 Amplituden A1 bzw. A2 voneinander verschiedenen Betrags |A1| ≠ |A2|. Dies bewirkt, daß auch die Summe I1+I2 der Intensitäten I1 und I2 dieser beiden Intensitätssignale L1 und L2 nicht konstant ist, sondern entsprechend dem Wechselstrom zeitlich periodisch schwankt.

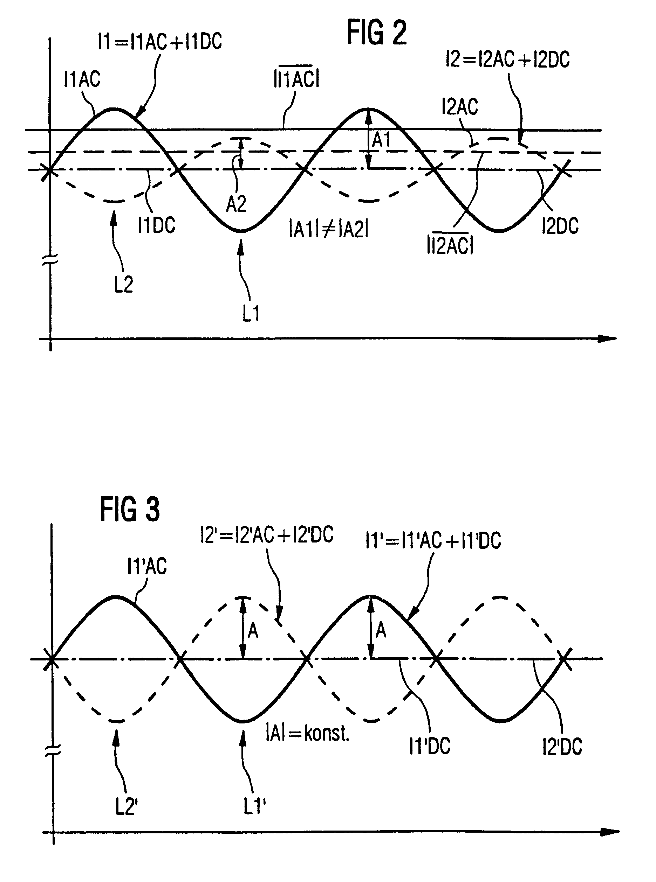

Dies sei an Hand der Figur 2 unter der Annahme, daß die Dämpfung des optischen Leiters $11_2$ größer als die des optischen Leiters $11_1$ ist, beispielhaft deutlich gemacht. In der Figur 2 ist das im optischen Leiter $11_1$ geführte Intensitätssignal L1 durchgezogen und das im optischen Leiter $11_2$ geführte Intensitätssignal L2 gestrichelt dargestellt. Die Intensität I1 des Intensitätssignals L1 besteht aus dem Gleichintensitätsanteil I1DC und dem auf den Pegel dieses Anteils I1DC bezogenen periodisch schwankenden Intensitätsanteil I1AC mit der Amplitude A1 des Betrags |A1|. Die Intensität I2 des Intensitätssignals L2 besteht aus dem Gleichintensitätsanteil I2DC und dem auf den Pegel dieses Anteils I2DC bezogenen periodisch schwankenden Intensitätsanteil I2AC mit der Amplitude A2 des Betrags |A2|. Wegen der im Vergleich zum optischen Leiter $11_1$ größeren Dämpfung im optischen Leiter $11_2$ ist der Betrag |A1| der Amplitude A1 des periodisch schwankenden Intensitätsanteils I1AC der Intensität I1 des im optischen Leiter $11_1$ geführten Intensitätssignals L1 größer als der Betrag |A2| der Amplitude A2 des periodisch schwankenden Intensitätsanteils I2AC der Intensität I2 des des im optischen Leiter $11_2$ geführten Intensitätssignals L2.

In der Figur 2 ist der Pegel des Gleichintensitätsanteil I2DC der Intensität I2 des im optischen optischen Leiter $11_2$ geführten Intensitätssignals L2 der Einfachheit halber gleich dem Pegel des Gleichintensitätsanteils I1DC der Intensität I1 des im optischen optischen Leiter $11_1$ geführten Intensitätssignals L1 gewählt. In Wirklichkeit ist aufgrund der relativ größeren Dämpfung im optischen Leiter $11_2$ der Pegel des Gleichintensitätsanteils I2DC ebenfalls kleiner als der Pegel des Gleichintensitätsanteil I1DC. Für die periodische Schwankung der Summe I1+I2 sind nicht die Gleichintensitätsanteile I1DC und I2DC, sondern nur die periodisch schwankenden Intensitätsanteile I1AC und I2AC verantwortlich.

Die Pegel der Gleichintensitätsanteile I1DC und I2DC der Intensitäten I1 und I2 der Intensitätssignale L1 und L2 sind in der Figur 2 zeitlich konstant dargestellt. Dies ist nur der Fall, wenn die Intensität I des dem Polarisationsstrahlteiler 12 zugeführten Lichts L konstant ist. Schwankt diese Intensität I, so schwanken auch die Gleichintensitätsanteile I1DC und I2DC der Intensitäten I1 und I2 der Intensitätssignale L1 und L2.

Erfindungsgemäß werden in der Gewinnungseinrichtung 2 von den beiden Intensitätssignalen L1 und L2 zwei Signale L1' und L2' mit den Intensitäten I1 bzw. I2 der beiden Intensitätssignalen L1 und L2 entsprechenden Signalintensitäten I1' bzw. I2' gewonnen, wobei die Signalintensitäten I1' bzw. I2' entsprechend den periodisch schwankenden Intensitätsanteilen I1AC bzw. I2AC der Intensitäten I1 bzw. I2 der Intensitätssignale L1 bzw. L2 zueinander gegenphasig periodisch schwankende Signalintensitätsanteile I1'AC bzw. I2'AC derart enthalten, daß

- die periodisch schwankenden Signalintensitätsanteile I1'AC bzw. I2'AC beider gewonnenen Signale L1' und L2' Amplituden A im wesentlichen gleichen Betrags |A| aufweisen und

- die Summe I1'+I2' der Signalintensitäten I1' und I2' beider gewonnenen Signale L1' und L2' im wesentlichen konstant ist.

In der Figur 3 sind die derart gewonnenen Signale L1' und L2' dargestellt, wobei das gewonnene Signal L1' durchgezogen und das gewonnene Signale L2' gestrichelt dargestellt ist. Die Signalintensität I1' des gewonnenen Signals L1' besteht aus dem Signal-Gleichintensitätsanteil I1'DC und dem auf den Pegel dieses Anteils I1'DC bezogenen periodisch schwankenden Signalintensitätsanteil I1'AC mit der Amplitude A des Betrags |A|. Die Signalintensität I2' des gewonnenen Signals L2' besteht aus dem Signal-Gleichintensitätsanteil I2'DC und dem auf den Pegel dieses Anteils I2'DC bezogenen periodisch schwankenden Signalintensitätsanteil I2'AC mit der Amplitude A des gleichen Betrags |A|. In der Figur 3 ist ebenfalls der Einfachheit halber der Pegel des Signal-Gleichintensitätsanteils I1'DC des gewonnenen Signals L1' gleich dem Pegel des Signal-Gleichintensitätsanteils I2'DC des gewonnenen Signals I2' gewählt. Dies ist jedoch nicht erforderlich.

Die beiden gewonnenen Signale L1' und L2' werden, beispielsweise über elektrische Leitungen $2_3$ bzw. $2_4$, einer Einrichtung 3 zur Bildung eines Quotienten zugeführt, in welcher aus den Intensitäten I1' und I2' der beiden abgeleiteten Signale L1' und L2' beispielsweise der aus der Differenz I1'-I2' zwischen diesen Intensitäten I1' und I2' und der Summe I1'+I2' dieser Intensitäten I1' und I2' bestehende Quotient P = (I1'-I2') / (I1'+I2') gebildet und zur Weiterverarbeitung ausgegeben wird, beispielsweise an einer elektrischen Leitung $3_1$.

Die Gewinnungseinrichtung 2 kann sowohl das Intensitätssignal L1 als auch das Intensitätssignal L2 verändern, jedoch ist beides zusammen nicht erforderlich. Die Gewinnungseinrichtung 2 kann so ausgebildet sein, daß nur eines der beiden Intensitätssignale relativ zum anderen verändert wird.

Bei dem Beispiel nach Figur 1 ist beispielsweise angenommen, daß die Gewinnungseinrichtung 2 die Intensität I1 des Intensitätssignals L1 unverändert läßt, so daß dieses Signal L1 zugleich das gewonnene Signal ist, d.h. L1 = L1' gilt, die Intensität I2 des Intensitätssignal L2 dagegen zur Amplitudenanpassung in die andere I2' Intensität das gewonnene Signal L2' abändert wird, so daß I2 ≠ I2' gilt. Es könnte auch umgekehrt sein, d.h. so, daß das Intensitätssignal L2 unverändert bleibt, d.h. L2 = L2' gilt, und das Intensitätssignal L1 in das davon verschiedene gewonnene Signal L1' umgewandelt wird.

Die beispielhafte Gewinnungseinrichtung 2 nach Figur 1 weist eine Multiplikationseinrichtung 20 zum Multiplizieren der Intensität I2 des Intensitätssignals L2 mit einem derart gewählten Korrekturfaktor k1 ≠ 1 auf, daß der periodisch schwankende Intensitätsanteil I2AC' = k1·I2AC der mit diesem Korrekturfaktor k1 multiplizierten Intensität k1·I2 = I2' des dadurch gebildeten gewonnenen Signals L2' und der periodisch schwankende Intensitätsanteil I1AC der unverändert belassenen Intensität I1 des zugleich das gewonnene Signal bildenden Intensitätssignals L1 jeweils die Amplitude A des gleichen Betrags |A| aufweisen.

Anstelle der Multiplikationseinrichtung 20 oder zusätzlich zu dieser könnte auch eine gestrichelt angedeutete Multiplikationseinrichtungn 22 zum Multiplizieren des Intensitätssignals I1 mit einem derart gewählten Korrekturfaktor k2 ≠ 1 vorgesehen sein, daß der periodisch schwankende Intensitätsanteil I1'AC = k2·I1AC der mit diesem Korrekturfaktor k2 multiplizierten Intensität I1' = k2·I1 des dadurch gebildeten gewonnenen Signals L1' und der periodisch schwankende Intensitätsanteil I2AC der unverändert belassenen Intensität I2 des zugleich das gewonnene Signal bildenden Intensitätssignals L2 jeweils die Amplitude A des gleichen Betrags |A| aufweisen.

Zur Bestimmung des Korrekturufaktors k1 und/oder k2, mit dem das betreffende Intensitätssignal I2 bzw. I1 zu multiplizieren ist, ist eine Korrekturfaktor-Bestimmungseinrichtung 21 vorgesehen.

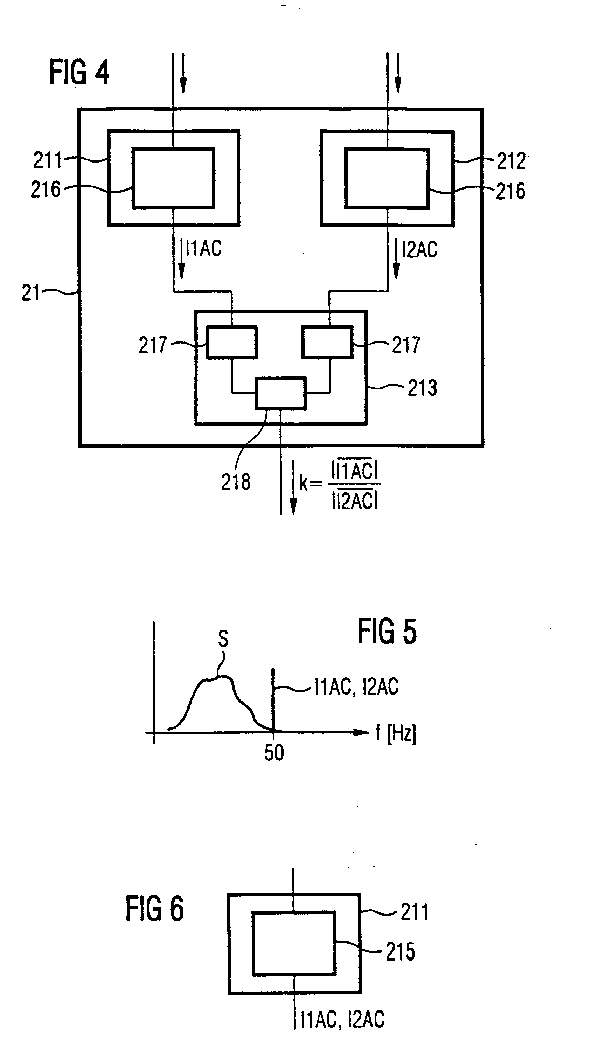

Ein Beispiel einer derartigen Korrekturfaktor-Bestimmungseinrichtung ist in der Figur 4 dargestellt. Diese beispielhafte Einrichtung 21 dient zur Bestimmung des Korrekturfaktors k1 und weist eine Einrichtung 212 zur Gewinnung des periodisch schwankenden Intensitätsanteils I2AC von dem mit diesem Korrekturfaktor k1 zu multiplizierenden Intensitätssignal L2, eine Einrichtung 211 zur Gewinnung des periodisch schwankenden Intensitätsanteils I1AC von dem anderen Intensitätssignal L1 und eine Einrichtung 213 zur Bildung eines diesen Koeffizienten k1 darstellenden bestimmten Quotienten $|\overline{I1AC}|$ / $|\overline{I2AC}|$ aus einer bestimmten amplitudenbezogenen betragsmäßigen Größe $|\overline{I1AC}|$ des vom anderen Intensitätssignal L1 gewonnenen periodisch schwankenden Intensitätsanteils I1AC und der gleichen amplitudenbezogenen betragsmäßigen Größe $|\overline{I2AC}|$ des vom einen Intensitätssignal L2 gewonnenen periodisch schwankenkenden Intensitätsanteils I2AC auf.

Zur Bildung des Korrekturfaktors k2 müßte die Einrichtung 213 so ausgebildet sein, daß der Quotient $|\overline{I2AC}|$ / $|\overline{I1AC}|$ gebildet wird.

Jede der Einrichtungen 211 und 212 zur Gewinnung des periodisch schwankenden Intensitätsanteils I1AC bzw. I2AC vom Intensitätssignal L1 bzw. L2 weist vorteilhafterweise eine Filtereinrichtung 216 zum Filtern des periodisch schwankenden Intensitätsanteils I1AC bzw. I2AC von seinem Intensitätssignal L1 bzw. L2 auf. Diese Filtereinrichtung 216 besteht im vorliegenden Fall, bei welchem die periodisch schwankenden Intensitätsanteile I1AC und I2AC bei nur einer festen Frequenz, der Wechselstromfrequenz von beispielsweise 50 Hz liegen, aus einem schmalbandigen Filter, das nur diese eine Frequenz durchläßt, alle anderen Frequenzen jedoch sperrt. Dadurch können alle Störschwankungen, die bei dieser festen Frequenz keine Amplitude ausreichend großen Betrags aufweisen, unschädlich gemacht werden.

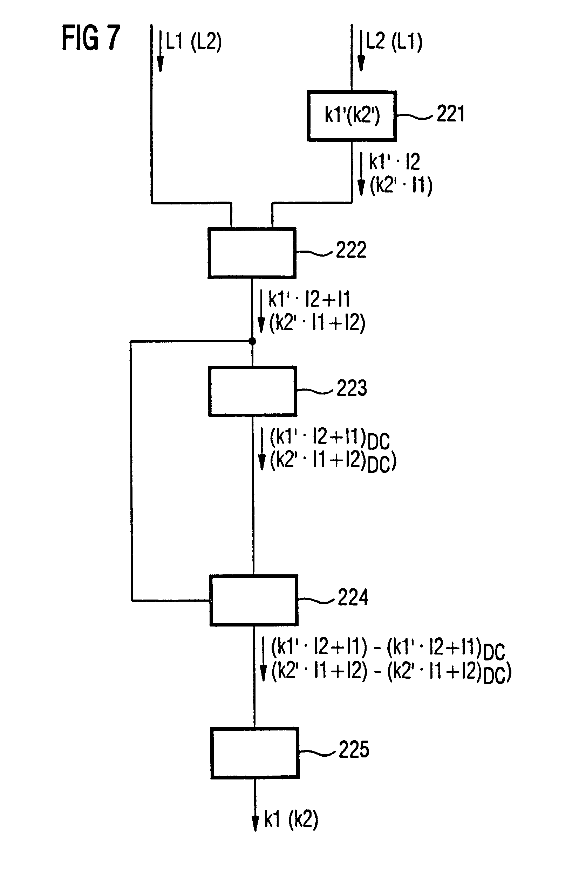

In der Figur 5 ist in einem Diagramm ein Beispiel für ein derartiges Frequenzspektrum dargestellt. In diesem Diagramm ist auf der Ordinate der Betrag der Amplitude der Intensitätssignale L1 und L2 sowie der von Störschwankungen in Abhängigkeit von der auf der Abszisse aufgetragenen Frequenz f aufgetragen Die Frequenz der periodisch schwankenden Intensitätsanteile I1AC bzw. I2AC der Intensitätssignale L1 und L2 liegt jeweils bei 50 Hz, das Frequenzspektrum der den Intensitätssignalen L1 und L2 überlagerten und beispielsweise durch mechanische Vibrationen verursachten Störschwankungen ist mit S bezeichnet.

Eine Einrichtung 211 bzw. 212 zur Gewinnung des periodisch schwankenden Intensitätsanteils I1AC bzw. I2AC vom betreffenden Intensitätssignal L1 bzw. L2 kann auch eine in Figur 6 angedeutete Differenzbildungseinrichtung 215 zur Bildung einer Differenz I1-I1DC bzw. I2-I2DC zwischen der Intensität I1 bzw. I2 dieses Intensitätssignals L1 bzw. L2 und dem Gleichintensitätsanteil I1DC bzw. I2DC dieses Intensitätssignals L1 bzw. L2 aufweisen. Diese Differenz I1-I1DC bzw. I2-I2DC bildet den periodisch schwankenden Intensitätsanteil I1AC bzw. I2AC des betreffenden Intensitätssignals L1 bzw. L2.

Die amplitudenbezogene betragsmäßige Größe ist vorzugsweise ein zeitliches Mittel |I1AC| bzw. |I2AC| des Betrags |I1AC| bzw. |I2AC|) des jeweiligen gewonnenen periodisch schwankenden Intensitätsanteils I1AC bzw. I2AC des betreffenden Intensitätssignals L1 bzw. L2. In diesem Fall ist eine Einrichtung 217 zur Erzeugung der bestimmten amplitudenbezogen betragsmäßige Größe in Form des zeitlichen Mittels |I1AC| bzw. |I2AC| des Betrags |I1AC|, |I2AC| des jeweiligen gewonnenen periodisch schwankenden Intensitätsanteils I1AC bzw. I2AC vorgesehen.

Bei einer alternativen Ausgestaltung einer erfindungsgemäßen Anordnung weist die Gewinnungseinrichtung 2

- eine Einrichtung 221 zum Multiplizieren der Intensität I2 bzw. I1 eines L2 bzw. L1 der beiden Intensitätssignale L1 und L2 mit einem einstellbaren vorläufigen Korrekturfaktor k1' bzw. k2',
- eine Einrichtung 222 zur Bildung einer Summenintensität k1'·I2+I1 bzw. k2'·I1+I2 durch Summation der mit dem vorläufigen Korrekturfaktor k1' bzw. k2' multiplizierten Intensität k1'·I2 bzw. k2'·I1 des einen Intensitätssignals L2 bzw. L1 und der unverändert belassenen Intensität I1 bzw. I2 des anderen Intensitätssignals L1 bzw. L2,
- eine Einrichtung 223 zur Ermittlung eines in der Summenintensität k1'·I2+I1 bzw. k2'·I1+I2 enthaltenen Gleichintensitätsanteils $(k1'·I2+I1)_{DC}$ bzw.

$(k2'·I1+I2)_{DC}$,

- eine Einrichtung 224 zur Bildung einer Differenzintensität (k1'·I2+I1) - $(k1'·I2+I1)_{DC}$ bzw. (k2'·I1+I2) - $(k1'·I2+I1)_{DC}$ aus der Summenintensität k1'·I2+I1 bzw. k2'·I1+I2 und deren Gleichintensitätsanteil $(k1'·I2+I1)_{DC}$ bzw.$(k2'·I1+I2)_{DC}$ und
- eine Einrichtung 225 zum Einstellen des vorläufigen Korrekturfaktors k1' bzw. k2' auf einen endgültigen Korrekturfaktor k1 bzw. k2 so, daß die Differenzintensität $(k1'·I2+I1)-(k1'·I2+I1)_{DC}$ bzw. (k2'·I1+I2) - $(k1'·I2+I1)_{DC}$) im wesentlichen gleich null ist, auf.

Die Einrichtung 225 ist vorzugsweise eine Regeleinrichtung.

Die Erfindung ist nicht auf den beispielhaft beschriebenen Wechselstromsensor 1 beschränkt sondern generell bei jedem Sensor anwendbar, wie er im Oberbegriff des Anspruchs 1 definiert ist, insbesondere auch bei Wechselspannungssensoren.

**Patentansprüche**

1.  Verfahren zur Intensitätsnormierung eines optischen Sensors (1) zum Messen eines elektrischen und/oder magnetischen Feldes (F) periodisch schwankender Feldstärke, bei welchem Sensor (1)

    - Licht (L) durch das Feld (F) geschickt,
    - von diesem durchgeschickten Licht (L) zwei voneinander getrennte, in Abhängigkeit von der periodisch schwankenden Feldstärke zueinander gegenphasig periodisch schwankende Intensitätsanteile (I1AC, I2AC) enthaltende Intensitäten (I1, I2) aufweisende Intensitätssignale (L1, L2) erzeugt werden und zur Intensitätsnormierung
    - aus den beiden Intensitätssignalen (L1, L2) eine Größe (P) abgeleitet wird, die einem Quotienten aus einer mit den Intensitäten (I1, I2) der beiden Intensitätssignale (L1, L2) gebildeten Differenz und einer mit diesen Intensitäten (I1, I2) gebildeten Summe entspricht,

    **dadurch gekennzeichnet, daß** von den beiden Intensitätssignalen (L1, L2)

    - zwei Signale (L1', L2') mit den Intensitäten (I1, I2) der beiden Intensitätssignale (L1, L2) entsprechenden Signalintensitäten (I1', I2') gewonnen werden, wobei
    - die Signalintensitäten (I1', I2') entsprechend den periodisch schwankenden Intensitätsanteilen (I1AC, I2AC) der Intensitäten (I1, I2) der Intensitätssignale (L1, L2) zueinander gegenphasig periodisch schwankende Signalintensitätsanteile (I1'AC, I2'AC) derart enthalten, daß

- die periodisch schwankenden Signalintensitätsanteile (I1'AC, I2'AC) beider gewonnenen Signale (L1', L2') Amplituden (A) im wesentlichen gleichen Betrags (|A|) aufweisen, und
- die Summe (I1'+I2') der Signalintensitäten (I1', I2') beider gewonnenen Signale (L1', L2') im wesentlichen konstant ist, und daß
- die Größe (P) durch den Quotienten aus einer Differenz (I1'-I2') der Signalintensitäten (I1', I2') der beiden gewonnenen Intensitätssignale (L1', L2') und der Summe (I1'+I2') dieser Signalintensitäten (I1', I2') bestimmt wird.

2. Verfahren nach Anspruch 1, **dadurch gekennzeichnet, daß** die beiden gewonnenen Signale (L1'; L2') dadurch gebildet werden, daß zumindest eines (L1; L2) der beiden Intensitätssignale (L1, L2) mit einem derart gewählten Korrekturfaktor (k2; k1) multipliziert wird, daß die zueinander gegenphasig periodisch schwankenden Signalintensitätsanteile (I1'AC, I2'AC) des durch Multiplikation mit diesem Korrekturfaktor (k2; k1) gewonnenen Signals (I1'=k2·I1; I2'=k1·I2) und des anderen gewonnenen Signals (L2'; L1') eine Amplitude (A) im wesentlichen gleichen Betrags (|A|) aufweisen.

3. Verfahren nach Anspruch 2, **dadurch gekennzeichnet, daß** zur Bestimmung des Korrekturfaktors (k2; k1), mit dem ein Intensitätssignal (L1; L2) zu multiplizieren ist, durch Bildung eines Quotienten ($|\overline{I2AC}|/|\overline{I1AC}|$; $|\overline{I1AC}|/|\overline{I2AC}|$) aus einer bestimmten amplitudenbezogen betragsmäßigen Größe ($|\overline{I1AC}|$; $|\overline{I2AC}|$) des periodisch schwankenden Intensitätsanteils (I1AC; I2AC) des anderen Intensitätssignals (L2; L1)) und der gleichen amplitudenbezogen betragsmäßigen Größe ($|\overline{I2AC}|$; $|\overline{I1AC}|$) des periodisch schwankenden Intensitätsanteils (I2AC; I1AC) des mit dem Korrekturfaktor (k2; k1) zu multiplizierenden einen Intensitätssignals (L1; L2) bestimmt wird.

4. Verfahren nach Anspruch 3, **dadurch gekennzeichnet, daß** ein periodisch schwankender Intensitätsanteil (I1AC, I2AC) eines Intensitätssignals (L1, L2) aus einer Differenz (I1-I1DC, I2-I2DC) zwischen der Intensität (I1, I2) dieses Intensitätssignals (L1, L2) und einem in diesem Intensitätssignal (L1, L2) enthaltenen konstanten Intensitätsanteil (I1DC, I2DC) gewonnen wird.

5. Verfahren nach Anspruch 3 oder 4, **dadurch gekennzeichnet, daß** ein periodisch schwankender Intensitätsanteil (I1AC, I2AC) durch Filterung des diesen Intensitätsanteil (I1AC, I2AC) enthaltenden Intensitätssignals (L1, L2) gewonnen wird.

6. Verfahren nach einem der Ansprüche 3 bis 5, **dadurch gekennzeichnet, daß** als bestimmte amplitudenbezogen betragsmäßige Größe eines periodisch schwankenden Intensitätsanteils (I1AC, I2AC) ein zeitliches Mittel ($|\overline{I1AC}|$, $|\overline{I2AC}|$) des Betrags (|I1AC|, |I2AC|) dieses Intensitätsanteils (I1AC, I2AC) verwendet wird.

7. Verfahren nach Anspruch 2, **dadurch gekennzeichnet, daß**

- die Intensität (I1; I2) eines (L1; L2) der beiden Intensitätssignale (L1, L2) mit einem einstellbaren vorläufigen Korrekturfaktor (k2'; k1') multipliziert,
- durch Summation der mit dem vorläufigen Korrekturfaktor (k2'; k1') multiplizierten Intensität (k2'·I1; k1'·I2) des einen Intensitätssignals (L1; L2) und der nicht mit einem Korrekturfaktor multiziplierten Intensität (I2; I1) des anderen Intensitätssignals (L2; L1) eine Summenintensität (k2'·I1+I2; k1'·I2+I1) gebildet,
- ein in der Summenintensität (k2'·I1+I2; k1'·I2+I1) enthaltener Gleichintensitätsanteil ((k2'·I1+I2)$_{DC}$; (k1'·I2+I1)$_{DC}$) ermittelt,
- aus der Summenintensität (k2'·I1+I2; k1'·I2+I1) und dem darin enthaltenen Gleichintensitätsanteil ((k2'·I1+I2)$_{DC}$; (k1'·I2+I1)$_{DC}$) eine Differenzintensität ((k2'·I1+I2)-(k2'·I1+I2)$_{DC}$; (k1'·I2+I1) - (k2'·I1+I2)$_{DC}$) gebildet und
- der vorläufige Korrekturfaktor (k2'; k1') auf einen endgültigen Korrekturfaktor (k2; k1) so eingestellt wird, daß die Differenzintensität ((k2'·I1+I2) - (k2'·I1+I2)$_{DC}$; (k1'·I2+I1)-(k1'·I2+I1)$_{DC}$) im wesentlichen gleich null ist.

8. Anordnung zur Durchführung eines Verfahrens nach einem der vorhergehenden Ansprüche, **gekennzeichnet durch**

- eine Gewinnungseinrichtung (2) zur Gewinnung von den beiden Intensitätssignalen (L1, L2) zweier Signale (L1', I2') die entsprechend den Intensitätsanteilen (I1AC, I2AC) der Intensitätssignale (L1, L2) zueinander gegenphasig periodisch schwankende Signalintensitätsanteile (I1'AC, I2'AC) derart aufweisen, daß
- die Signalintensitätsanteile (I1'AC, I2'AC) beider gewonnenen Signale (L1', L2') Amplituden (A) im wesentlichen gleichen Betrags (|A|) aufweisen und
- die Summe (I1'+I2' der Intensitäten (I1', I2') beider gewonnenen Signale (L1', I2') im wesentlichen konstant ist und eine
- Einrichtung (3) zur Bildung eines Quotienten (P) aus einer Differenz (I1'-I2') der beiden gewonnenen Signale (I1, I2'; I1', I2; I1', I2') und deren Summe (I1+I2'; I1'+I2; I1'+I2').

9. Anordnung nach Anspruch 8 zur Durchführung eines Verfahrens nach Anspruch 2, **dadurch gekennzeichnet, daß** die Gewinnungseinrichtung (2)

- eine Multiplikationseinrichtung (20) zum Multiplizieren zumindest eines (L1; L2) der beiden Intensitätssignale (L1, L2) mit einem derart gewählten Korrekturfaktor (k2; k1) aufweist, daß die zueinander gegenphasig periodisch schwankenden Signalintensitätsanteile (I1'AC, I1'AC) des durch Multiplikation dieses einen Intensitätssignals (L1; L2) mit diesem Korrekturfaktor (k1; k2) gewonnenen Signals (k2·L1=L1' ; k1·L2=L2') und des anderen gewonnenen Signals (L2'; L1') Amplituden (A) im wesentlichen gleichen Betrags (|A|) aufweisen.

10. Anordnung nach Anspruch 9 zur Durchführung eines Verfahrens nach Anspruch 3, **gekennzeichnet durch**

- eine Korrekturfaktor-Bestimmungseinrichtung (21) zur Bestimmung des Korrekturfaktors (k2; k1), mit dem ein Intensitätssignal (L1; L2) zu multiplizieren ist.

11. Anordnung nach Anspruch 10, **dadurch gekennzeichnet, daß** die Korrekturfaktor-Bestimmungseinrichtung (21)

- eine Einrichtung (212) zur Gewinnung des periodisch schwankenden Intensitätsanteils (I1AC; I2AC) von dem Intensitätssignal (L1; L2), das mit dem Korrekturfaktor (k2; k1) zu multiplizieren ist,
- eine Einrichtung (211) zum Ableiten des periodisch schwankenden Intensitätsanteils (I2AC; I1AC) von dem anderen Intensitätssignal (L2; L1)

und

- eine Einrichtung (213) zur Bildung eines diesen Koeffizienten (k2; k1 darstellenden Quotienten (|I2AC|/|I1AC|; |I1AC|/|I2AC|) aus einer bestimmten amplitudenbezogen betragsmäßigen Größe (|I2AC|; |I1AC|) des vom anderen Intensitätssignal (L2; L1) gewonnenen periodisch schwankenden Intensitätsanteils (I2AC; I1AC) und der gleichen amplitudenbezogen betragsmäßigen Größe (|I1AC|; |I2AC|) des vom einen Intensitätssignal (L1; L2) gewonnenen periodisch schwankenden Intensitätsanteils (I1AC; I2AC).

12. Anordnung nach Anspruch 11, **dadurch gekennzeichnet, daß** eine Einrichtung (211, 212) zur Gewinnung des periodisch schwankenden Intensitätsanteils (I1AC; I2AC) von einem Intensitätssignal (L1; L2) eine Differenzbildungseinrichtung (215) zur Bildung einer Differenz (I1-I1DC, I2-I2DC) zwischen der Intensität (I1, I2) dieses Intensitätssignals (L1, L2) und einem Gleichintensitätsanteil (I1DC, I2DC) dieses Intensitätssignals (L1, L2) aufweist.

13. Anordnung nach Anspruch 11 oder 12, **dadurch gekennzeichnet, daß** eine Einrichtung (211, 212) zum Ableiten des periodisch schwankenden Intensitätsanteils (I1AC; I2AC) von einem Intensitätssignal (L1; L2) eine Filtereinrichtung (216) zum Filtern des periodisch schwankenden Intensitätsanteils (I1AC; I2AC) von seinem Intensitätssignal (L1, L2) aufweist.

14. Anordnung nach einem der Ansprüche 10 bis 13, **gekennzeichnet durch** eine Einrichtung (217) zur Erzeugung der bestimmten amplitudenbezogen betragsmäßigen Größe in Form eines zeitliches Mittels (|I1AC|, |I2AC|) des Betrags (|I1AC|, |I2AC|) des jeweiligen gewonnenen periodisch schwankenden Intensitätsanteils (I1AC, I2AC).

15. Anordnung nach Anspruch 8, **dadurch gekennzeichnet, daß** die Gewinnungseinrichtung (2)

- eine Einrichtung (221) zum Multiplizieren der Intensität (I1; I2) eines (L1; L2) der beiden Intensitätssignale (L1, L2) mit einem einstellbaren vorläufigen Korrekturfaktor (k2'; k1'),
- eine Einrichtung (222) zur Bildung einer Summenintensität (k2'·I1+I2; k1'·I2+I1) durch Summation der mit dem vorläufigen Korrekturfaktor (k2'; k1') multiplizierten Intensität (k2'·I1; k1'·I2) des einen Intensitätssignals (L1; L2) und der nicht mit einem Korrekturfaktor multiziplierten Intensität (I2; I1) des anderen Intensitätssignals (L2; L1),
- eine Einrichtung (223) zur Ermittlung eines in der Summenintensität (k2'·I1+I2; k1'·I2+I1) enthaltenen Gleichintensitätsanteils ((k2'·I1+I2)$_{DC}$; (k1'·I2+I1)$_{DC}$),
- eine Einrichtung (224) zur Bildung einer Differenzintensität ((k2'·I1+I2)-(k2'·I1+I2)$_{DC}$; (k1'·I2+I1)-(k2'·I1+I2)$_{DC}$) aus der Summenintensität (k2'·I1+I2; k1'·I2+I1) und dem darin enthaltenen Gleichintensitätsanteil ((k2'·I1+I2)$_{DC}$; (k1'·I2+I1)$_{DC}$) und
- eine Einrichtung (225) zum Einstellen des vorläufigen Korrekturfaktors (k2'; k1') auf einen endgültigen Korrekturfaktor (k2; k1) so, daß die Differenzintensität ((k2'·I1+I2)-(k2'·I1+I2)$_{DC}$; (k1'·I2+I1) - (k1'·I2+I1)$_{DC}$) im wesentlichen

gleich null ist, aufweist.

## Claims

1. Method for normalizing the intensity of an optical sensor (1) for measuring an electrical and/or magnetic field (F) of cyclically fluctuating field strength, in which sensor (1)

   - light (L) is transmitted through the field (F),
   - this transmitted light (L) generates two mutually isolated intensity signals (L1, L2) which have intensities (I1, I2) containing intensity components (I1AC, I2AC) which fluctuate cyclically in antiphase with respect to one another on the basis of the cyclically fluctuating field strength, and, for the purposes of intensity normalization,
   - the two intensity signals (L1, L2) are used to derive a variable (P) which corresponds to a quotient comprising a difference formed using the intensities (I1, I2) of the two intensity signals (L1, L2) and a sum formed using these intensities (I1, I2),

   **characterized in that**, from the two intensity signals (L1, L2),

   - two signals (L1', L2') having signal intensities (I1', I2') which correspond to the intensities (I1, I2) of the two intensity signals (L1, L2) are obtained, where
   - the signal intensities (I1', I2') contain signal intensity components (I1'AC, I2'AC), fluctuating cyclically in antiphase with respect to one another on the basis of the cyclically fluctuating intensity components (I1AC, I2AC) of the intensities (I1, I2) of the intensity signals (L1, L2), such that
   - the cyclically fluctuating signal intensity components (I1'AC, I2'AC) of the two signals (L1', L2') obtained have amplitudes (A) of essentially the same magnitude (|A|), and
   - the sum (I1'+I2') of the signal intensities (I1', I2') of the two signals (L1', L2') obtained is essentially constant, and in that
   - the variable (P) is determined by the quotient comprising a difference (I1'-I2') for the signal intensities (I1', I2') of the two intensity signals (L1', L2') obtained and the sum (I1'+I2') of these signal intensities (I1', I2').

2. Method according to Claim 1, **characterized in that** the two signals (L1'; L2') obtained are formed by virtue of at least one (L1; L2) of the two intensity signals (L1, L2) being multiplied by a correction factor (k2; k1) which is chosen such that the signal intensity components (I1'AC, I2'AC), fluctuating cyclically in antiphase with respect to one another, of the signal (I1'=k2·I1; I2'=k1·I2) obtained by multiplication by this correction factor (k2; k1) and of the other signal (L2'; L1') obtained have an amplitude (A) of essentially the same magnitude (|A|).

3. Method according to Claim 2, **characterized in that**, to determine the correction factor (k2; k1) by which an intensity signal (L1; L2) is to be multiplied, formation of a quotient ($|\overline{I2AC}|$ / $|\overline{I1AC}|$; $|\overline{I1AC}|$ / $|\overline{I2AC}|$) from a particular amplitude magnitude variable ($|\overline{I1AC}|$; $|\overline{I2AC}|$) for the cyclically fluctuating intensity component (I1AC; I2AC) of the other intensity signal (L2; L1) and from the same amplitude magnitude variable ($|\overline{I2AC}|$; $|\overline{I1AC}|$) for the cyclically fluctuating intensity component (I2AC; I1AC) of the one intensity signal (L1; L2) to be multiplied by the correction factor (k2; k1) determines [lacuna].

4. Method according to Claim 3, **characterized in that** a cyclically fluctuating intensity component (I1AC, I2AC) of an intensity signal (L1, L2) is obtained from a difference (I1-I1DC, I2-I2DC) between the intensity (I1, I2) of this intensity signal (L1, L2) and a constant intensity component (I1DC, I2DC) contained in this intensity signal (L1, L2).

5. Method according to Claim 3 or 4, **characterized in that** a cyclically fluctuating intensity component (I1AC, I2AC) is obtained by filtering the intensity signal (L1, L2) containing this intensity component (I1AC, I2AC).

6. Method according to one of Claims 3 to 5, **characterized in that** the particular amplitude magnitude variable used for a cyclically fluctuating intensity component (I1AC, I2AC) is an average over time ($|\overline{I1AC}|,|\overline{I2AC}|$) for the magnitude ($|\overline{I1AC}|,|\overline{I2AC}|$) of this intensity component (I1AC, I2AC).

7. Method according to Claim 2, **characterized in that**

   - the intensity (I1; I2) of one (L1; L2) of the two intensity signals (L1, L2) is multiplied by a settable provisional correction factor (k2'; k1'),
   - a sum intensity (k2'·I1+I2; k1'·I2+I1) is formed by summation of the intensity (k2'·I1; k1'·I2), multiplied by the provisional correction factor (k2'; k1'), of one intensity signal (L1; L2) and the intensity (I2; I1), not multiplied by a correction factor, of the other intensity signal (L2; L1),
   - a DC intensity component ((k2'·I1+I2)$_{DC}$; (k1'·I2+I1)$_{DC}$) contained in the sum intensity (k2'·I1+I2; k1'· I2+I1) is ascertained,
   - a difference intensity ((k2'·I1+I2) - (k2'·I1+I2)$_{DC}$; (k1'·I2+I1)-(k2'·I1+I2)$_{DC}$) is formed from the sum intensity (k2'·I1+I2; k1'·I2+I1) and the DC intensity component ((k2'·I1+I2)$_{DC}$; (k1'·I2+I1)$_{DC}$) contained therein, and
   - the provisional correction factor (k2'; k1') is set to a final correction factor (k2; k1) such that the difference intensity $((k2'\cdot I1+I2) - (k2'\cdot I1+I2)_{DC};$ $(k1'\cdot I2+I1)-(k1'\cdot I2+I1)_{DC})$ is essentially equal to zero.

8. Arrangement for carrying out a method as claimed in one of the preceding claims, **characterized by**

   - an obtainment device (2) for obtaining the two intensity signals (L1, L2) of two signals (L1', I2') which have signal intensity components (I1'AC, I2'AC) fluctuating cyclically in antiphase with respect to one another on the basis of the intensity components (I1AC, I2AC) of the intensity signals (L1, L2) such that
   - the signal intensity components (I1'AC, I2'AC) of the two signals (L1', L2') obtained have amplitudes (A) of essentially the same magnitude (|A|), and
   - the sum (I1'+I2') of the intensities (I1', I2') of the two signals (L1, I2') obtained is essentially constant, and a
   - device (3) for forming a quotient (P) from a difference (I1'-I2') for the two signals (I1, I2'; I1', I2; I1', I2') obtained and the sum thereof (I1+I2'; I1'+I2; I1'+I2').

9. Arrangement according to Claim 8 for carrying out a method according to Claim 2, **characterized in that** the obtainment device (2)

   - has a multiplication device (20) for multiplying at least one (L1; L2) of the two intensity signals (L1, L2) by a correction factor (k2; k1) which is chosen such that the signal intensity components (I1'AC, I2'AC), fluctuating cyclically in antiphase with respect to one another, of the signal (k2·L1=L1'; k1· L2=L2') obtained by multiplying this one intensity signal (L1; L2) by this correction factor (k1; k2) and of the other signal (L2'; L1') obtained have amplitudes (A) of essentially the same magnitude (|A|).

10. Arrangement according to Claim 9 for carrying out a method according to Claim 3, **characterized by**

    - a correction factor determination device (21) for determining the correction factor (k2; k1) by which an intensity signal (L1; L2) needs to be multiplied.

11. Arrangement according to Claim 10, **characterized in that** the correction factor determination device (21) has

    - a device (212) for obtaining the cyclically fluctuating intensity component (I1AC; I2AC) from the intensity signal (L1; L2) which is to be multiplied by the correction factor (k2; k1),
    - a device (211) for deriving the cyclically fluctuating intensity component (I2AC; I1AC) from the other intensity signal (L2; L1), and
    - a device (213) for forming a quotient (|I2AC|/ |I1AC|; |I1AC|/|I2AC|), which represents this coefficient (k2; k1), from a particular amplitude magnitude variable (|I2AC|; |I1AC|) for the cyclically fluctuating intensity component (I2AC/ I1AC) obtained from the other intensity signal (L2; L1) and from the same amplitude magnitude variable (|I1AC|; |I2AC|) for the cyclically fluctuating intensity component (I1AC; I2AC) obtained from the one intensity signal (L1; L2).

12. Arrangement according to Claim 11, **characterized in that** a device (211, 212) for obtaining the cyclically fluctuating intensity component (I1AC; I2AC) from an intensity signal (L1; L2) has a difference formation device (215) for forming a difference (I1-I1DC, I2-I2DC) between the intensity (I1, I2) of this intensity signal (L1, L2) and a DC intensity component (I1DC, I2DC) of this intensity signal (L1, L2).

13. Arrangement according to Claim 11 or 12, **characterized in that** a device (211, 212) for deriving the cyclically fluctuating intensity component (I1AC; I2AC) from an intensity signal (L1; L2) has a filter device (216) for filtering the cyclically fluctuating intensity component (I1AC, I2AC) from its intensity signal (L1, L2).

14. Arrangement according to one of Claims 10 to 13, **characterized by** a device (217) for producing the particular amplitude magnitude variable in the form of an average over time (|I1AC|, |I2AC|) for the magnitude (|I1AC|, |I2AC|) of the respective cyclically fluctuating intensity component (I1AC, I2AC) obtained.

15. Arrangement according to Claim 8, **characterized in that** the obtainment device (2) has

    - a device (221) for multiplying the intensity (I1; I2) of one (L1; L2) of the two intensity signals (L1, L2) by a settable provisional correction factor (k2'; k1'),
    - a device (222) for forming a sum intensity (k2'· I1+I2; k1'·I2+I1) by summation of the intensity (k2'·I1; k1'·I2), multiplied by the provisional correction factor (k2'; k1'), of one intensity signal (L1; L2) and the intensity (I2; I1), not multiplied by a correction factor, of the other intensity signal (L2; L1),
    - a device (223) for ascertaining a DC intensity component $((k2'\cdot I1+I2)_{DC}; (k1'\cdot I2+I1)_{DC})$ contained in the sum intensity (k2'·I1+I2; k1'·I2+I1),
    - a device (224) for forming a difference intensity

$((k2' \cdot I1+I2) - (k2' \cdot I1+I2)_{DC}; (k1' \cdot I2+I1) - (k2' \cdot I1+I2)_{DC})$ from the sum intensity $(k2' \cdot I1+I2; k1' \cdot I2+I1)$ and the DC intensity component $((k2' \cdot I1+I2)_{DC}; (k1' \cdot I2+I1)_{DC})$ contained therein, and

- a device (225) for setting the provisional correction factor (k2'; k1') to a final correction factor (k2; k1) such that the difference intensity $((k2' \cdot I1+I2)-(k2' \cdot I1+I2)_{DC}; (k1' \cdot I2+I1)-(k1' \cdot I2+I1)_{DC})$ is essentially equal to zero.

## Revendications

1. Procédé de normalisation de l'intensité d'un capteur optique (1) destiné à la mesure d'un champ électrique et/ou magnétique (F), dont l'intensité varie périodiquement,

   - de la lumière (L) étant envoyée, dans le dit capteur (1), à travers le champ (F),
   - à partir de cette lumière (L) envoyée à travers le champ, deux signaux d'intensité (L1, L2), ayant des intensités (I1, I2) contenant des fractions d'intensité (I1AC, I2AC), qui varient périodiquement en opposition de phase l'une par rapport à l'autre en fonction de la variation périodique de l'intensité du champ, étant générés et pour la normalisation de l'intensité
   - une grandeur (P) étant dérivée à partir des deux signaux d'intensité (L1, L2), qui correspond à un quotient d'une différence formée à partir des intensités (I1, I2) des deux signaux d'intensité (L1, L2) et d'une somme formée à partir de ces intensités (I1, I2),

   caractérisé par le fait que, à partir des deux signaux d'intensité (L1, L2),

   - on extrait deux signaux (L1', L2') avec des intensités de signal (I1', I2') correspondant aux intensités (I1, I2) des deux signaux d'intensité (L1, L2),
   - les intensités de signal (I1', I2') comprenant des fractions d'intensité de signal (I1'AC, I2'AC), qui varient périodiquement en opposition de phase l'une par rapport à l'autre en fonction des fractions d'intensité (I1AC, I2AC), qui varient périodiquement, des intensités (I1, I2) des signaux d'intensité (L1, L2), de telle sorte que
   - les fractions d'intensité de signal (I1'AC, I2'AC), qui varient périodiquement, des deux signaux obtenus (L1', L2') ont des amplitudes (A), pour l'essentiel, de même valeur |A| et
   - la somme (I1' + I2') des intensités de signal (I1', I2') des deux signaux obtenus (L1', L2') est, pour l'essentiel, constante et
   - la grandeur (P) est déterminée par le quotient d'une différence (I1'- I2') des intensités de signal (I1', I2') des deux signaux obtenus (L1', L2') et de la somme (I1' + I2') de ces intensités de signal (I1', I2').

2. Procédé selon la revendication 1 caractérisé par le fait que les deux signaux obtenus (L1'; L2') sont formés en multipliant au moins un (L1, L2) des deux signaux d'intensité (L1, L2) par un facteur de correction (k2; k1) choisi de telle sorte que les fractions d'intensité de signal (I1'AC, I2'AC), qui varient périodiquement en opposition de phase l'une par rapport à l'autre, du signal (I1' = k2·I1; I2' = k1·I2) obtenu par multiplication par ce facteur de correction (k2; k1) et de l'autre signal obtenu (L2'; L1') ont une amplitude (A), pour l'essentiel, de même valeur |A|.

3. Procédé selon la revendication 2 caractérisé par le fait que, pour la détermination du facteur de correction (k2; k1), avec lequel il faut multiplier un signal d'intensité (L1; L2) est déterminé en formant un quotient $(\overline{|I2AC|} / \overline{|I1AC|}); (\overline{|I1AC|} / \overline{|I2AC|})$ à partir d'une grandeur déterminée $(\overline{|I1AC|}; \overline{|I2AC|})$, dont la valeur correspond à l'amplitude, de la fraction d'intensité (I1AC; I2AC), qui oscille périodiquement, de l'autre signal d'intensité (L2; L1) et de la même grandeur déterminée, $(\overline{|I2AC|}; \overline{|I1AC|})$, dont la valeur correspond à l'amplitude, de la fraction d'intensité (I2AC; I1AC), qui oscille périodiquement, du signal d'intensité (L1; L2) à multiplier avec le facteur de correction (k2; k1).

4. Procédé selon la revendication 3 caractérisé par le fait qu'une fraction d'intensité (I1AC; I2AC), qui oscille périodiquement, d'un signal d'intensité (L1, L2) est obtenue à partir d'une différence (I1-I1DC, I2-I2DC) entre l'intensité (I1, I2) de ce signal d'intensité (L1, L2) et une fraction d'intensité constante (I1DC, I2DC) contenue dans ce signal d'intensité (L1, L2).

5. Procédé selon la revendication 3 ou 4 caractérisé par le fait qu'une fraction d'intensité (I1AC; I2AC), qui oscille périodiquement, est obtenue par filtration du signal d'intensité (L1, L2) contenant cette fraction d'intensité (I1AC; I2AC).

6. Procédé selon l'une des revendications 3 à 5 caractérisé par le fait que, comme grandeur déterminée, dont la valeur correspond à l'amplitude, d'une fraction d'intensité (I1AC; I2AC), qui oscille périodiquement, on utilise une moyenne dans le temps $(\overline{|I1AC|}; \overline{|I2AC|})$ de valeur (|I1AC|; |I2AC|) de cette fraction d'intensité (I1AC; I2AC).

7. Procédé selon la revendication 2 caractérisé par le fait que

- l'intensité (I1, I2) d'un (L1; L2) des deux signaux d'intensité (L1, L2) est multipliée par un facteur provisoire de correction réglable (k2'; k1'),
- on forme une intensité additive (k2'·I1+I2; k1'·I2+I1) en additionnant l'intensité (k2'·I1; k1'·I2) multipliée par le facteur provisoire de correction (k2'; k1') de l'un des signaux d'intensité (L1; L2) et l'intensité (I2; I1), non multipliée par un facteur de correction, de l'autre signal d'intensité (L2; L1),
- on détermine une fraction d'intensité continue $((k2'·I1+I2)_{DC}; (k1'·I2+I1)_{DC})$ contenue dans l'intensité additive (k2'·I1+I2; k1'·I2+I1),
- on forme, à partir de l'intensité additive (k2'·I1+I2; k1'·I2+I1) et de la fraction d'intensité continue $((k2'·I1+I2)_{DC}; (k1'·I2+I1)_{DC})$ qu'elle contient, une intensité différentielle $((k2'·I1+I2) - (k2'·I1+I2)_{DC}; (k1'·I2+I1) - k2'·I1+I2)_{DC})$ et
- le facteur provisoire de correction (k2'; k1') est réglé sur un facteur de correction définitif (k2; k1) de telle sorte que l'intensité différentielle $((k2'·I1+I2)-(k2'·I1+I2)_{DC}; (k1'·I2+I1) - k2'·I2+I1)_{DC})$ est, pour l'essentiel, égale à zéro.

8. Dispositif pour exécuter le procédé selon l'une des revendications précédentes **caractérisé par**

  - un système de préparation (2) pour préparer, à partir des deux signaux d'intensité (L1, L2), deux signaux (L1', L2') qui comportent des fractions d'intensité de signal (I1'AC, I2'AC), qui varient périodiquement en opposition de phase l'une par rapport à l'autre en fonction des fractions d'intensité (I1AC, I2AC) des signaux d'intensité (L1, L2), de telle sorte que
  - les fractions d'intensité de signal (I1'AC, I2'AC) des deux signaux obtenus (L1', L2') ont des amplitudes (A), pour l'essentiel, de même valeur |A| et
  - la somme (I1' + I2') des intensités (I1', I2') des deux signaux obtenus (L1', L2') est, pour l'essentiel, constante et
  - un dispositif (3) pour la formation d'un quotient (P) à partir d'une différence (I1'- I2') des deux signaux obtenus (I1, I2'; I1', I2; I1', I2') et de leur somme (I1 + I2'; I1' + I2; I1' + I2').

9. Dispositif selon la revendication 8 pour exécuter un procédé selon la revendication 2 **caractérisé par le fait** que le système de préparation (2)

  - comporte un dispositif de multiplication (20) pour multiplier au moins un (L1; L2) des deux signaux d'intensité (L1, L2) par un facteur de correction (k2; k1) choisi de telle sorte que les fractions d'intensité des signaux (I1'AC, I1'AC), qui oscillent périodiquement en opposition de phase l'une par rapport à l'autre, du signal obtenu (k2·L1 = L1'; k1·L2 = L2') par multiplication de ce signal d'intensité (L1; L2) par ce facteur de correction (k1; k2) et de l'autre signal obtenu (L2'; L1') ont l'amplitude A, pour l'essentiel, de même valeur (|A|).

10. Dispositif selon la revendication 9 pour exécuter un procédé selon la revendication 3 **caractérisé par**

  - un dispositif (21) de détermination du facteur de correction pour déterminer le facteur de correction (k2; k1) par lequel il faut multiplier un signal d'intensité (L1; L2).

11. Dispositif selon la revendication 10 **caractérisé par le fait** que le dispositif (21) de détermination du facteur de correction comporte

  - un dispositif (212) pour la préparation de la fraction d'intensité (I1AC; I2AC), qui oscille périodiquement, du signal d'intensité (L1; L2) qu'il faut multiplier par le facteur de correction (k2; k1),
  - un dispositif (211) pour l'extraction de la fraction d'intensité (I2AC; I1AC), qui oscille périodiquement, de l'autre signal d'intensité (L2; L1) et
  - un dispositif (213) pour la formation d'un quotient (|I2AC| / |I1AC|; |I1AC| / |I2AC|) représentant un de ces coefficients (k2; k1), à partir d'une grandeur déterminée, (|I2AC|, |I1AC|), dont la valeur correspond à l'amplitude, de la fraction d'intensité (I2AC; I1AC) obtenue à partir de l'autre signal d'intensité (L2; L1) et qui oscille périodiquement, et de la même grandeur déterminée, (|I1AC|;|I2AC|), dont la valeur correspond à l'amplitude, de la fraction d'intensité (I1AC; I2AC) obtenue à partir du premier signal d'intensité (L1; L2) et qui oscille périodiquement.

12. Dispositif selon la revendication 11 **caractérisé par le fait** qu'un dispositif (211, 212) pour préparer la fraction d'intensité (I1AC; I2AC), qui oscille périodiquement, à partir d'un signal d'intensité (L1; L2), comporte un dispositif (215) de formation de différence pour former une différence (I1 - I1DC, 12-I2DC) entre l'intensité (I1, I2) de ce signal d'intensité (L1, L2) et une fraction continue d'intensité (I1DC, I2DC) de ce signal d'intensité (L1, L2).

13. Dispositif selon la revendication 11 ou 12 **caractérisé par le fait** qu'un dispositif (211, 212) pour extraire la fraction d'intensité (I1AC; I2AC), qui oscille périodiquement, d'un signal d'intensité (L1; L2), comporte un dispositif (216) de filtrage pour filtrer la fraction d'intensité (I1AC; I2AC), qui oscille périodiquement, de son signal d'intensité (L1; L2).

**14.** Dispositif selon l'une des revendications 10 à 13 **caractérisé par** un dispositif (217) pour générer la grandeur déterminée, dont la valeur correspond à l'amplitude, sous forme d'une moyenne dans le temps ($\overline{|I1AC|}$, $\overline{|I2AC|}$) de la valeur (|I1AC|, |I2AC|) de la fraction d'intensité respective obtenue (I1AC, I2AC), qui varie périodiquement.

**15.** Dispositif selon la revendication 8 **caractérisé par le fait** que le dispositif de préparation (2) comporte

- un dispositif (221) pour multiplier l'intensité (I1; I2) d'un (L1;L2) des deux signaux d'intensité (L1, L2) par un facteur provisoire de correction réglable (k2'; k1'),
- un dispositif (222) pour former une intensité additive (k2'·I1+I2; k1'·I2+I1) par addition de l'intensité (k2'·I1; k1'·I2) multipliée par le facteur provisoire de correction (k2'; k1') de l'un des signaux d'intensité (L1; L2) et de l'intensité (I2; I1) non multipliée par un facteur de correction de l'autre signal d'intensité (L2; L1),
- un dispositif (223) pour déterminer une fraction d'intensité continue ((k2'·I1+I2)$_{DC}$; (k1'·I2+I1)$_{DC}$) contenue dans l'intensité additive (k2'·I1+I2; k1'·I2+I1),
- un dispositif (224) pour former une intensité différentielle ((k2'·I1+I2)-(k2'·I1+I2)$_{DC}$; (k1'·I2+I1) - (k2'·I1+I2)$_{DC}$) à partir de l'intensité additive (k2'·I1+I2; k1'·I2+I1) et de sa fraction d'intensité continue qu'elle renferme ((k2'·I1+I2)$_{DC}$; (k1'·I2+I1)$_{DC}$) et
- un dispositif (225) pour régler le facteur provisoire de correction (k2'; k1') sur un facteur définitif de correction (k2; k1) de telle sorte que l'intensité différentielle ((k2'·I1+I2) - (k2'·I1+I2)$_{DC}$; (k1'·I2+I1) - (k1'·I2+I1)$_{DC}$) soit, pour l'essentiel, égale à zéro.

FIG 1

$$P = \frac{I1' - I2'}{I1' + I2'}$$

FIG 2

I1 = I1AC + I1DC

I1AC

$\overline{|I1AC|}$

I2 = I2AC + I2DC

I2AC

A1

I1DC

A2

L2

L1

$|A1| \neq |A2|$

$\overline{|I2AC|}$

I2DC

FIG 3

I2' = I2'AC + I2'DC

I1' = I1'AC + I1'DC

I1'AC

A

A

$|A| = $ konst.

I1'DC

I2'DC

L2'

L1'

**FIG 4**

211
216

212
216

↓ I1AC          ↓ I2AC

21

217          217

213

218          ↓ $k = \dfrac{|\overline{I1AC}|}{|\overline{I2AC}|}$

**FIG 5**

S

I1AC, I2AC

50          f [Hz]

**FIG 6**

211
215

I1AC, I2AC

**FIG 7**

↓L1 (L2)  ↓L2 (L1)

┌─────────┐
│ k1'(k2') │ ～ 221
└─────────┘

↓ k1' · I2
(k2' · I1)

┌─────────┐
│         │ ～ 222
└─────────┘

↓ k1' · I2+I1
(k2' · I1+I2)

┌─────────┐
│         │ ～ 223
└─────────┘

↓ (k1' · I2+I1)DC
(k2' · I1+I2)DC)

┌─────────┐
│         │ ～ 224
└─────────┘

↓ (k1' · I2+I1) − (k1' · I2+I1)DC
(k2' · I1+I2) − (k2' · I1+I2)DC)

┌─────────┐
│         │ ～ 225
└─────────┘

↓ k1 (k2)